# EUROPEAN PATENT APPLICATION

(11) **EP 4 395 504 A2**
(43) Date of publication of application: **03.07.2024**
(21) Application number: 23220420.6
(22) Date of filing: 28.12.2023
(51) Int. Cl.: H10K 59/121, H10K 59/80

(54) **DISPLAY DEVICE**

(30) Priority: 30.12.2022 KR 20220191259
(71) Applicant: LG Display Co., Ltd., Seoul 07336 (KR)
(72) Inventor: KO, Taehee, 10845 Paju-si (KR); PARK, Sunghee, 10845 Paju-si (KR)
(74) Representative: Morrall, Jonathan Ian McLachlan

(57) **Abstract**

A display device includes a display panel including a light emitting area and a non-light emitting area located outside the light emitting area; a plurality of sub-pixels disposed on the display panel; a plurality of color filters disposed to respectively correspond to the plurality of sub-pixels; a dam pattern disposed at least on the non-light emitting area of the display panel; an overcoat layer disposed between the color filters and the dam pattern; and a slit pattern located in a cutting area of the non-light emitting area.

## Description

### BACKGROUND

### Field of the Disclosure

The present disclosure relates to a display device, and more particularly, to a display device capable of blocking moisture and oxygen invading path to an organic light-emitting element to improve reliability of the organic light-emitting element of the display device.

### Description of the Background

A display device is applied to various electronic devices such as TVs, mobile phones, laptops and tablets. To this end, research to develop thinning, lightening, and low power consumption of the display device is continuing.

Examples of the display device include a liquid crystal display device (LCD), a plasma display device (PDP), a field emission display device (FED), an electro-wetting display device (EWD), and an organic light-emitting display device (OLED).

The organic light-emitting display device (OLED) includes a plurality of pixel areas disposed in a display area where an image is displayed, and a plurality of organic light-emitting elements corresponding to the plurality of pixel areas. Since the organic light-emitting element is a self-light-emitting element that emits light by itself, the organic light-emitting display device has advantages of faster response speed, greater luminous efficiency, luminance and larger viewing angle, and an excellent contrast ratio and color reproduction compared to the liquid crystal display device.

The organic light-emitting element includes an organic material that can be easily deteriorated by moisture and oxygen. Accordingly, research is being conducted on a scheme to block an invading path of the moisture and oxygen to prevent the organic material from deteriorating.

Moreover, demand for a display apparatus capable of realizing a large-area screen in which a plurality of display devices are arranged, and a display apparatus having various sizes in which a plurality of display devices are arranged is increasing. Accordingly, it has become an important issue to implement the display apparatus of various sizes while blocking the invading path of moisture and oxygen to the organic light-emitting element to improve the quality of the display apparatus.

### SUMMARY

Accordingly, the present disclosure is directed to a display device that substantially obviates one or more of problems due to limitations and disadvantages described above.

Additional features and advantages of the disclosure will be set forth in the description which follows and in part will be apparent from the description, or may be learned by practice of the disclosure. Other advantages of the present disclosure will be realized and attained by the structure particularly pointed out in the written description and claims hereof as well as the appended drawings.

More specifically, the present disclosure is to provide a display device which may be cut into a display device of various sizes and in which a void as one of the causes of deterioration of an organic light-emitting element can be blocked to maintain performance of the organic light-emitting element.

The present disclosure is also to provide a display device capable of preventing an occurrence of a void resulted from a step generated as color filters overlap with each other.

The present disclosure is yet to provide a display device capable of preventing an occurrence of a void resulted from a decrease in an adhesive strength between a dam pattern disposed in an area other than a display area and a color filter.

Further, the present disclosure is to provide a display device capable of cleaning a substrate without damaging a color filter.

The present disclosure is not limited to the above-mentioned features. Other features and advantages according to the present disclosure that are not mentioned may be understood based on following descriptions, and may be more clearly understood based on examples according to the present disclosure. Further, it will be easily understood that the purposes and advantages according to the present disclosure may be realized using means shown in the claims or combinations thereof.

In an aspect of the present disclosure, a display device includes a display panel including a light emitting area and a non-light emitting area located outside the light emitting area; a plurality of sub-pixels disposed on the display panel; a plurality of color filters disposed to respectively correspond to the plurality of sub-pixels; a dam pattern disposed at least on the non-light emitting area of the display panel; an overcoat layer disposed between the color filters and the dam pattern; and a slit pattern located in close proximity to a cutting area of the non-light emitting area.

In another aspect of the present disclosure, a display device includes first and second substrates facing each other; first, second, third and fourth organic light-emitting elements disposed on the first substrate in a non-emissive area; a dam pattern disposed on the first, second, third and fourth organic light-emitting elements; first, second, third and fourth sub-pixels disposed on the display panel; first, second and third color filters disposed to respectively correspond to the first, second, third organic light-emitting elements; an overcoat layer disposed on the second substrate including the first, second and third color filter layers; and a barrier layer disposed between the dam pattern and the overcoat layer and having first and second portions overlapping with the second organic light-emitting element and the fourth organic light-emitting element.

According to the aspect of the present disclosure, preventing the void which may act as an invading path of the moisture and oxygen in a display device that may be cut to implement a display device of various sizes from occurring may allow the performance and lifetime of the organic light-emitting element to be maintained for a long time.

According to the aspect of the present disclosure, maintaining the performance and lifetime of the organic light-emitting element for a long time may secure the quality of an image in the display device at a low power level, thereby reducing power consumption.

According to the aspect of the present disclosure, the flat surface may be realized by disposing the overcoat layer on the color filter, so that the occurrence of the void resulted from the step between the color filters may be prevented to block the invading path of the moisture and the oxygen, thereby securing the reliability of the product.

According to the aspect of the present disclosure, the overcoat layer with the flat surface may be disposed between the color filter and the dam pattern, so that the occurrence of the void in the non-pad area resulted from the decrease in the adhesive strength between the dam pattern and the color filter may be prevented.

According to the aspect of the present disclosure, as the plurality of slit patterns are disposed in the direction perpendicular to a direction of the moisture invading path, the moisture may be blocked from invading to the display area, and thus, a long lifespan of the organic light-emitting element disposed inside the display area may be realized, so that the display device may be driven even with the low power, and thus, the power consumption may be reduced.

Moreover, according to the aspect of the present disclosure, as the overcoat layer for covering the color filter is disposed, the substrate may be cleaned without damaging the color filter, so that the foreign substances that act as the dark spot on the display area may be removed, thereby improving the reliability of the product.

Effects of the present disclosure are not limited to the effects mentioned above, and other effects not mentioned will be clearly understood by those skilled in the art from the descriptions below.

### BRIEF DESCRIPTION OF THE DRAWINGS

The accompanying drawings, which are included to provide a further understanding of the disclosure and are incorporated in and constitute a part of the disclosure, illustrate aspects of the disclosure and together with the description serve to explain the principle of the disclosure.

In the drawings:
FIG. 1 is a schematic plan view of a display device according to an aspect of the present disclosure.
FIG. 2 is a schematic plan view of a light-transmissive area and a light-emissive area of a display area of a display device according to an aspect of the present disclosure.
FIG. 3A and FIG. 3B are example views a portion of a non-pad area of a display device according to an aspect of the present disclosure.
FIG. 4A is an enlarged plan view of area 4A in FIG. 1.
FIG. 4B is a cross-sectional view taken along arrow 4B-4B in FIG. 4A.
FIG. 5 is an enlarged plan view of area 5 in FIG. 1.
FIG. 6 is a cross-sectional view taken along arrow 6-6 in FIG. 5.
FIG. 7 is an enlarged plan view of area 7 in FIG. 1.
FIGs. 8 to 11 are views schematically showing cross-sections of respective portions in FIG. 7; and
FIG. 12 is a cross-sectional view showing a display device according to another aspect of the present disclosure.

### DETAILED DESCRIPTION

Advantages and features of the present disclosure, and a method of achieving the advantages and features will become apparent with reference to examples described later in detail together with the accompanying drawings. However, the present disclosure is not limited to the examples as disclosed under, but may be implemented in various different forms. Thus, these examples are set forth only to make the present disclosure complete, and to completely inform the scope of the present disclosure to those of ordinary skill in the technical field to which the present disclosure belongs.

For simplicity and clarity of illustration, elements in the drawings are not necessarily drawn to scale. The same reference numbers in different drawings represent the same or similar elements, and as such perform similar functionality. Further, descriptions and details of well-known steps and elements are omitted for simplicity of the description. Furthermore, in the following detailed description of the present disclosure, numerous specific details are set forth to provide a thorough understanding of the present disclosure. However, it will be understood that the present disclosure may be practiced without these specific details. In other instances, well-known methods, procedures, components, and circuits have not been described in detail so as not to unnecessarily obscure aspects of the present disclosure. Examples of various examples are illustrated and described further below. It will be understood that the description herein is not intended to limit the claims to the specific examples described. On the contrary, it is intended to cover alternatives, modifications, and equivalents as may be included within the spirit and scope of the present disclosure as defined by the appended claims.

A shape, a size, a ratio, an angle, a number, etc. disclosed in the drawings for describing examples of the present disclosure are illustrative, and the present disclosure is not limited thereto. The same reference numerals refer to the same elements herein. Further, descriptions and details of well-known steps and elements are omitted for simplicity of the description. Furthermore, in the following detailed description of the present disclosure, numerous specific details are set forth to provide a thorough understanding of the present disclosure. However, it will be understood that the present disclosure may be practiced without these specific details. In other instances, well-known methods, procedures, components, and circuits have not been described in detail so as not to unnecessarily obscure aspects of the present disclosure.

The terminology used herein is directed to the purpose of describing particular examples only and is not intended to be limiting of the present disclosure. As used herein, the singular constitutes "a" and "an" are intended to include the plural constitutes as well, unless the context clearly indicates otherwise. It will be further understood that the terms "comprise", "including", "include", and "including" when used in this specification, specify the presence of the stated features, integers, operations, elements, and/or components, but do not preclude the presence or addition of one or more other features, integers, operations, elements, components, and/or portions thereof. As used herein, the term "and/or" includes any and all combinations of one or more of associated listed items. Expression such as "at least one of" when preceding a list of elements may modify the entire list of elements and may not modify the individual elements of the list. In interpretation of numerical values, an error or tolerance therein may occur even when there is no explicit description thereof.

In addition, it will also be understood that when a first element or layer is referred to as being present "on" a second element or layer, the first element may be disposed directly on the second element or may be disposed indirectly on the second element with a third element or layer being disposed between the first and second elements or layers. It will be understood that when an element or layer is referred to as being "connected to", or "connected to" another element or layer, it may be directly on, connected to, or connected to the other element or layer, or one or more intervening elements or layers may be present. In addition, it will also be understood that when an element or layer is referred to as being "between" two elements or layers, it may be the only element or layer between the two elements or layers, or one or more intervening elements or layers may also be present.

Further, as used herein, when a layer, film, region, plate, or the like is disposed "on" or "on a top" of another layer, film, region, plate, or the like, the former may directly contact the latter or still another layer, film, region, plate, or the like may be disposed between the former and the latter. As used herein, when a layer, film, region, plate, or the like is directly disposed "on" or "on a top" of another layer, film, region, plate, or the like, the former directly contacts the latter and still another layer, film, region, plate, or the like is not disposed between the former and the latter. Further, as used herein, when a layer, film, region, plate, or the like is disposed "below" or "under" another layer, film, region, plate, or the like, the former may directly contact the latter or still another layer, film, region, plate, or the like may be disposed between the former and the latter. As used herein, when a layer, film, region, plate, or the like is directly disposed "below" or "under" another layer, film, region, plate, or the like, the former directly contacts the latter and still another layer, film, region, plate, or the like is not disposed between the former and the latter.

In descriptions of temporal relationships, for example, temporal precedent relationships between two events such as "after", "subsequent to", "before", etc., another event may occur therebetween unless "directly after", "directly subsequent" or "directly before" is not indicated.

When a certain aspect may be implemented differently, a function or an operation specified in a specific block may occur in a different order from an order specified in a flowchart. For example, two blocks in succession may be actually performed substantially concurrently, or the two blocks may be performed in a reverse order depending on a function or operation involved.

It will be understood that, although the terms "first", "second", "third", and so on may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described under could be termed a second element, component, region, layer or section, without departing from the spirit and scope of the present disclosure.

The features of the various examples of the present disclosure may be partially or entirely combined with each other, and may be technically associated with each other or operate with each other. The examples may be implemented independently of each other and may be implemented together in an association relationship.

In interpreting a numerical value, the value is interpreted as including an error range unless there is no separate explicit description thereof.

It will be understood that when an element or layer is referred to as being "connected to", or "connected to" another element or layer, it may be directly on, connected to, or connected to the other element or layer, or one or more intervening elements or layers may be present. In addition, it will also be understood that when an element or layer is referred to as being "between" two elements or layers, it may be the only element or layer between the two elements or layers, or one or more intervening elements or layers may also be present.

The features of the various examples of the present disclosure may be partially or entirely combined with each other, and may be technically associated with each other or operate with each other. The examples may be implemented independently of each other and may be implemented together in an association relationship.

Unless otherwise defined, all terms including technical and scientific terms used herein have the same meaning as commonly understood by one of ordinary skill in the art to which this inventive concept belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein, "embodiments," "examples," "aspects, and the like should not be construed such that any aspect or design as described is superior to or advantageous over other aspects or designs.

Further, the term 'or' means 'inclusive or' rather than 'exclusive or'. That is, unless otherwise stated or clear from the context, the expression that 'x uses a or b' means any one of natural inclusive permutations.

The terms used in the description below have been selected as being general and universal in the related technical field. However, there may be other terms than the terms depending on the development and/or change of technology, convention, preference of technicians, etc. Therefore, the terms used in the description below should not be understood as limiting technical ideas, but should be understood as examples of the terms for describing examples.

Further, in a specific case, a term may be arbitrarily selected by the applicant, and in this case, the detailed meaning thereof will be described in a corresponding description section. Therefore, the terms used in the description below should be understood based on not simply the name of the terms, but the meaning of the terms and the contents throughout the Detailed Descriptions.

Hereinafter, a display device according to the present disclosure will be described with reference to the accompanying drawings.

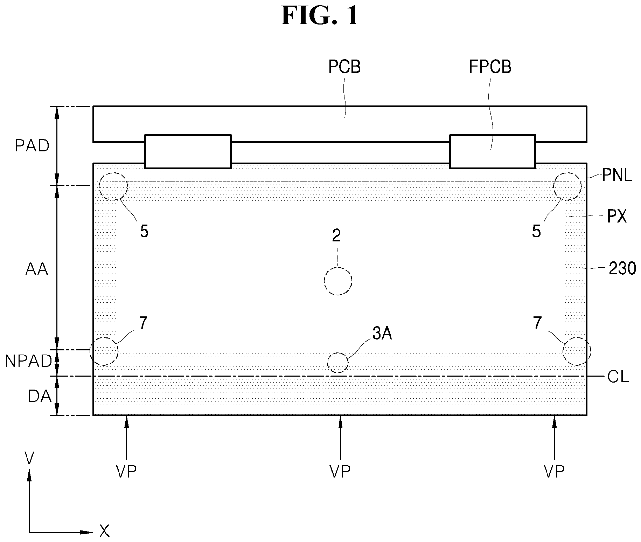

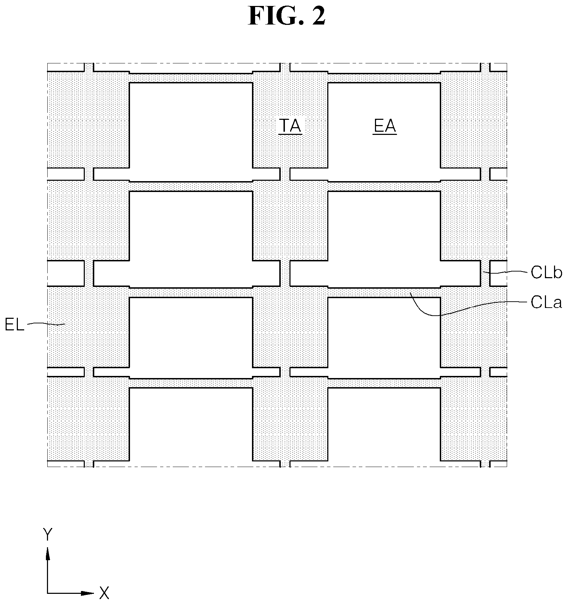

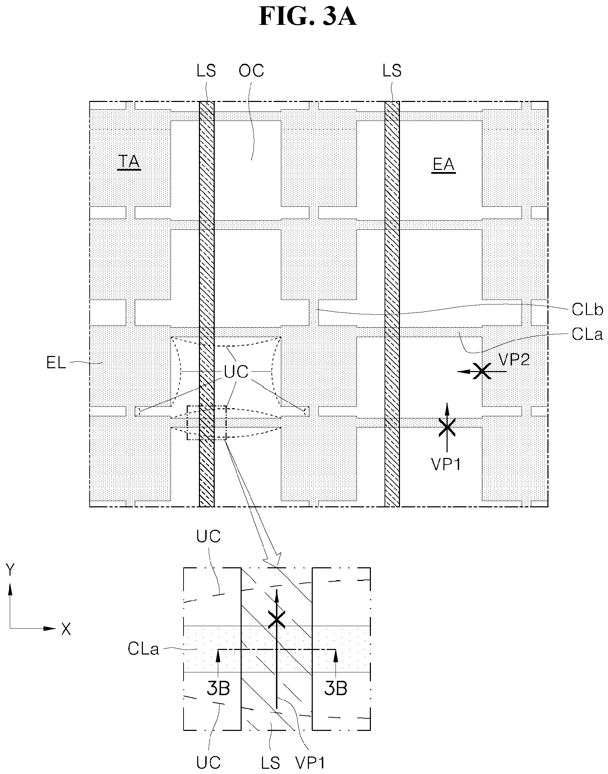

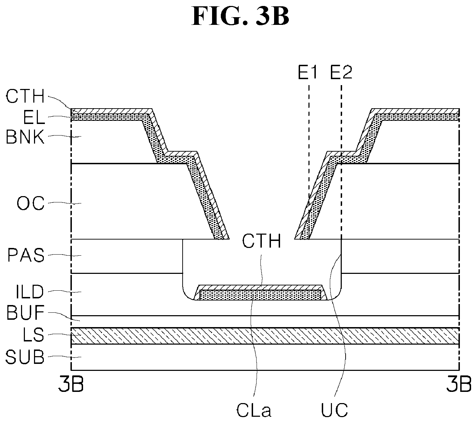

FIG. 1 is a schematic plan view of a display device according to an aspect of the present disclosure. FIG. 2 is a schematic plan view of a light-transmissive area and a light-emissive area of a display area of a display device according to an aspect of the present disclosure. FIG. 3A and FIG. 3B are example views a portion of a non-pad area of a display device according to an aspect of the present disclosure.

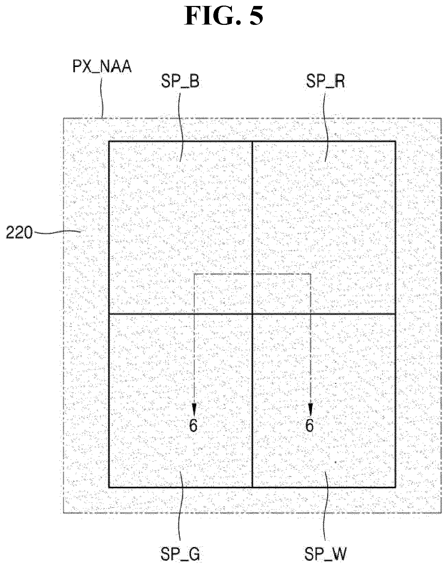

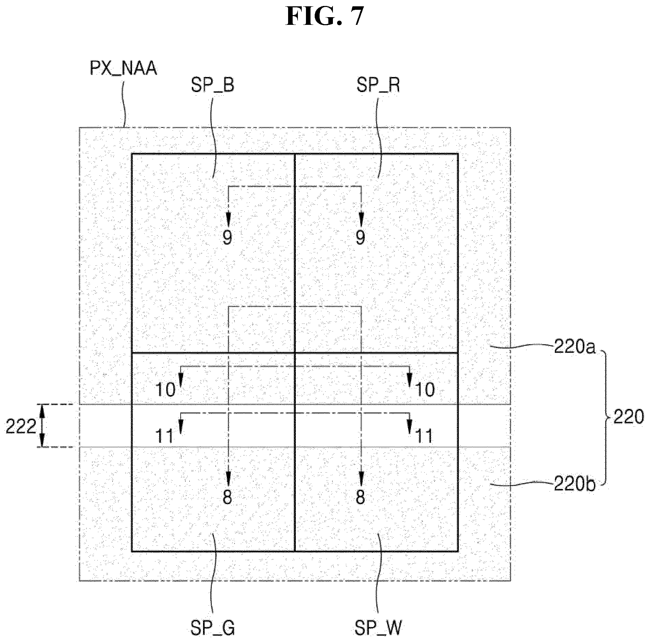

FIG. 1 shows a display panel PNL, a dam pattern 230, a printed circuit board PCB, a flexible circuit board FPCB, an active area AA (or display area) including a pixel area PX and a non-display area including a pad area PAD, a non-pad area NPAD, a removed area DA, and a cutting line CL, a moisture invading path direction VP, area 3 (shown in FIG. 3), area 5 (shown in FIG. 5) and area 7 (shown in FIG. 7).

Referring to FIG. 1, the display panel PNL of the display device according to the aspect of the present disclosure may have a structure in which a first substrate on which a thin-film transistor and an organic light-emitting element are disposed and a second substrate on which a color filter is disposed are bonded together. In this regard, detailed descriptions of the first substrate and the second substrate will be made with reference to FIGs. 2 to 4B.

The display panel PNL may include the display area AA, the pad area PAD, and the non-pad area NPAD. The display panel PNL may have a shape in which a length of one side is greater than a length of the other side. For example, the display panel PNL may include a long side and a short side shorter than the long side.

The display device according to an aspect of the present disclosure may be a transparent display device that displays an image and transmits light such that an object disposed on a rear surface of the display panel PNL can be recognized by a user.

As one of methods for transparently implementing the display panel PNL, a light-transmissive area TA and a light-emissive area EA may be distinguished from each other on the display panel PNL, and light may be transmitted in the light-transmissive area TA such that the rear surface of the display panel may be recognized. To this end, the light-transmissive area TA may be an area in which a non-transparent material or a reflective material is not disposed. Moreover, an organic material layer EL, which is a light-emissive layer, may be included in the each of the light-transmissive area TA and the light-emissive area EA. An organic light-emitting element may include the organic material layer, an anode and a cathode, where the organic material layer may be disposed between the anode and the cathode.

The display area AA, as an area where the image is displayed, may include the plurality of sub-pixel sub pixels in the light-emissive area EA. Each sub-pixel is an area that emits light corresponding to a certain color. Among the plurality of sub-pixels, three or four or more sub-pixels adjacent to each other and corresponding to different colors may form one pixel area emitting light of various colors. That is, by a combination of light emitted from two or more sub-pixels that implement one pixel area and are adjacent to each other, the pixel area may render various colors and emit the image to the display area AA. For example, the sub-pixels constituting one pixel area may emit light corresponding to a color such as green (G), blue (B), and red (R), or emit light corresponding to a color of green (G), blue (B), or red (R) and white (W).

The pad area PAD may be an area where the flexible circuit board FPCB and the printed circuit board PCB are disposed. The flexible circuit board FPCB and the printed circuit board PCB may be disposed on an edge of at least one side of the display panel PNL. An integrated circuit chip may be disposed on the flexible circuit board FPCB. The flexible circuit board FPCB may be coupled to the printed circuit board PCB and may supply power and various signals for driving the organic light-emitting element from the printed circuit board PCB to the display area AA. For example, the various signals may include a high-potential voltage, a low-potential voltage, a scan signal, a data signal, or the like.

The printed circuit board PCB may supply signals to the integrated circuit chip disposed on the flexible circuit board FPCB. Various parts for supplying the various signals to the integrated circuit chip may be disposed on the printed circuit board PCB. In FIG. 1, one printed circuit board PCB is shown, but the present disclosure is not limited thereto. For example, the plurality of printed circuit boards PCB may be disposed on the edge at one side of the display panel PNL.

The non-pad area NPAD may be located on an edge of the other side opposite to the pad area PAD disposed on one side of the display panel PNL. A cutting line CL may be disposed on the edge of the other side opposite to the pad area PAD of the display panel PNL. A removed area DA is an area to be separated and removed when cutting the display panel PNL via the cutting line CL. In addition, a portion of the edge of the other side opposite to the pad area PAD excluding the removed area DA that is removed by the cutting line CL may be the non-pad area NPAD. As a demand for display devices with various sizes increases, research on such devices are being conducted. Among them, there is a method to introduce the display panel PNL that may be cut. In the display panel PNL that may be cut, the cutting line CL is disposed. The display panel PNL may be cut via the cutting line CL to have a size of a display device to be realized.

In a case of a display panel with an already determined size of the display device, the organic light-emitting element may only be disposed on the display area. However, in the display panel PNL that may be cut, a pixel area PX where a pixel in which the organic light-emitting element is disposed is formed may be disposed extending from the display area AA to the non-pad area NPAD. That is, the light-transmissive area TA and the light-emissive area EA may be disposed extending to the non-pad area NPAD.

Referring to FIGs 1 to 3B, the display area AA or the non-pad area NPAD may include the plurality of light-transmissive areas TA and the plurality of light-emissive areas EA. In the light-transmissive area TA, light may be transmitted such that the object disposed on the rear surface of the display panel PNL may be recognized, and the organic material layer EL may be disposed. In addition, the light-emissive area EA may include the plurality of sub-pixels and various circuit elements for driving the sub-pixels.

Each of the plurality of light-transmissive areas TA may be spaced apart from each other with each light-emissive area EA interposed therebetween. First and second connection lines CLa and CLb may be disposed between two adjacent light-transmissive areas TA. The connection lines CLa and CLb may include the first connection line CLa and the second connection line CLb.

The first connection line CLa may be disposed between each two of the light-transmissive areas TA arranged in a first direction, and the second connection line CLb may be disposed between each two of the light-transmissive areas TA arranged in a second direction different from the first direction. In this regard, the first direction may be an X-axis direction and the second direction may be a Y-axis direction. Moreover, the first direction may be a horizontal direction, and the second direction may be a vertical direction. The first connection line CLa and the second connection line CLb may contain the same material as an organic material constituting the organic light-emitting element.

The size of the display panel (PNL) that can be cut can be adjusted through the cutting line (CL). Accordingly, the light-transmissive areas TA and the light-emissive areas EA arranged in the display area AA may be disposed extending to the non-pad area NPAD. In other words, a plurality of light-transmissive areas TA including an organic material layer and a plurality of light-emissive areas EA may be disposed in the non-pad area NPAD. The organic material layer may be easily deteriorated by moisture or oxygen. Accordingly, the edge of the other side of the display panel PNL where the non-pad area NPAD is located may be a moisture invading path. A moisture invading path direction VP, as indicated by an arrow in FIG. 1 may proceed from the other side edge of the display panel PNL toward the display area AA. In addition, invasion of moisture and oxygen may occur via the organic light-emitting element disposed on the non-pad area NPAD in the moisture invading path direction VP.

As the organic light-emitting element contains the organic material that may be easily deteriorated by the moisture and the oxygen, a method for blocking a portion that is an invading path of the moisture and the oxygen becomes an important issue.

In the example of the present disclosure, one method of preventing moisture or oxygen from penetrating into the display area AA may include disconnecting the organic material layer disposed on the non-pad area NPAD. Further details are described below with reference to other drawings in this disclosure.

FIG. 3A and FIG. 3B are example views according to and one example of the present disclosure. In particular, FIG. 3B illustrates an example of a cross-sectional view taken along a line 3B-3B in FIG. 3A.

Referring to FIG. 3A and FIG. 3B, the non-pad area NPAD may include a plurality of light-transmissive areas TA and a plurality of light-emissive areas EA. The transmissive area TA may be an area in which an opaque material or a reflective material is not disposed. Adjacent ones of the plurality of light-transmissive areas TA may be spaced apart from each other while the light-emissive areas EA is interposed therebetween. The light-transmissive areas TA may be arranged to be spaced apart from each other in a first direction (eg, X-axis direction) and a second direction (eg, Y-axis direction) different from the first direction.

The substrate SUB of the light-emissive areas EA of the non-pad area NPAD may include a light blocking layer wiring LS. The light blocking layer wiring LS may extend along the same first direction as the light-transmissive area TA disposed in the first direction. A buffer insulation layer BUF, an interlayer insulation layer ILD, a passivation layer PAS, an overcoat layer OC, a bank BNK, an organic material layer EL, and a cathode layer CTH disposed over the light blocking layer line LS.

In FIG. 3A, for convenience of explanation, the organic material layer EL is shown to be disposed only in the light-transmissive area TA, the organic material layer EL may be disposed on the front of the display device. Accordingly, the organic material layer EL may be disposed on the overcoat layer OC in the light-emissive areas EA. As the organic material layer EL is disposed on the overcoat layer OC of the light-emissive areas EA, the first connection line CLa and the second connection line CLb are formed between adjacent light-transmissive areas TA, thereby ensuring the reliability of the display device. For example, if the periphery of the light-transmissive area TA is surrounded only by the overcoat layer OC, moisture may penetrate into the display area AA through the organic material layer EL disposed on top of the overcoat layer OC.

To prevent moisture from penetrating into the display area AA, an undercut structure UC may be disposed below the overcoat layer OC on the light-emissive areas EA. Specifically, the undercut structure UC may be located along the each boundary of the light-transmissive area TA. The undercut structure UC can separate the overcoat layer OC and prevent the light-transmissive area TA from being surrounded only by the overcoat layer OC. When the undercut structure UC is formed below the overcoat layer OC and then the organic material layer EL is stacked, the continuity of the organic material layer EL between adjacent light-transmissive areas TA may be interrupted and separated each other. As a result, the first connection line CLa and the second connection line CLb may be formed. For example, the first connection line CLa is disposed between neighboring light-transmissive areas TA in the first direction (eg, X-axis direction), and the second connection line CLb is disposed between neighboring light-transmissive areas TA in the second direction (eg, Y-axis direction).

In addition, unlike the display area AA, the non-pad area NPAD has an undercut structure UC disposed below the overcoat layer OC on both sides of the first connection line CLa and the second connection line CLa to disconnect an organic material layer EL on the top of the overcoat layer OC. This can ensure the reliability of the display device. The undercut structure UC may be disposed below the overcoat layer OC on which the organic material layer EL is disposed. The undercut structure UC has a shape in which the end E1 of the overcoat layer OC protrudes outwardly than the end E2 of the interlayer dielectric layer ILD or the passivation layer PAS by removing inwardly the interlayer dielectric layer ILD and the passivation layer PAS.

Referring again to FIG. 3A, the first connection line CLa is disposed between of the light-transmissive areas TA arranged in the first direction (e.g., X-axis direction), the second connection line CLb may be disposed between of the light-transmissive areas TA arranged in the second direction (eg, Y-axis direction). The first connection line CLa and the second connection line CLb may include the same material as the organic material layer EL. The undercut structure UC may be disposed below the overcoat layer OC in a second direction different from the first connection line CLa disposed in the first direction. Alternatively, the undercut structure UC may be disposed under the overcoat layer OC in the first direction, which is different from the second connection line CLa disposed in the second direction.

Referring to FIGS 3A and 3B, the undercut structure UC is formed below the overcoat layer OC in a second direction (Y-axis direction). The undercut structure UC disconnects the organic material layer EL and the first connection line CLa disposed on the overcoat layer OC in the second direction (Y-axis direction). As a result, it is possible to prevent the moisture permeation path VP1 from occurring in the second direction (Y-axis direction).

According to an example of the present disclosure, the cuttable display panel PNL disconnects the organic material layer disposed on the non-pad area NPAD through the undercut structure UC. This can prevent moisture or oxygen from penetrating into the display area AA.

The dam pattern 230 may be disposed to prevent the invasion of the moisture and the oxygen to the organic light-emitting element of the display panel PNL along with the undercut structure disposed on the non-pad area NPAD. The dam pattern 230 may have a shape surrounding four edges of the display panel PNL. The dam pattern 230 may block the oxygen and the moisture from invading to the display area AA.

In the aspect of the present disclosure, by improving a performance of an adhesion between the dam pattern 230 and other components disposed in the pad area PAD or the non-pad area NPAD, the invading path of the moisture and the oxygen may be blocked. This will be described with reference to the drawings below.

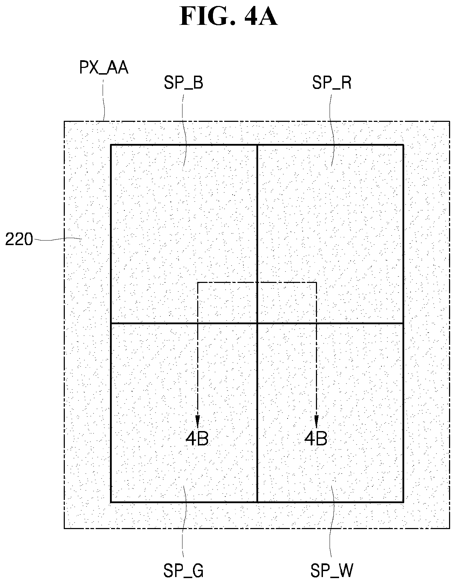

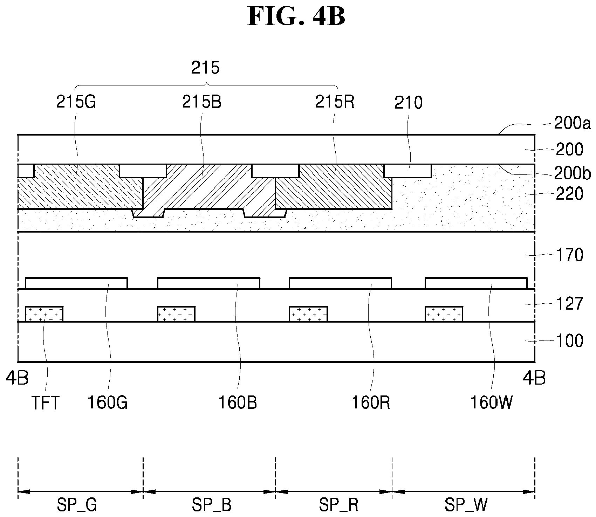

FIG. 4A is an enlarged plan view of one pixel area disposed on the display area in FIG. 2. In addition, FIG. 4B is a cross-sectional view taken along arrow 4B-4B in FIG. 4A. In this regard, FIG. 4A shows a structure of the display device corresponding to a pixel area PX_AA disposed in the light-emissive area EA located on the display area AA.

Referring to FIGs. 1 to 4B, each pixel area PX_AA disposed in the light-emissive area EA located on the display area AA includes the plurality of sub-pixels. Each of the plurality of sub-pixels may include the organic light-emitting element, which is a self-light-emitting element, and a thin-film transistor for driving the organic light-emitting element.

One pixel area PX_AA may be implemented by including the plurality of sub-pixels in which at least three sub-pixels are disposed adjacent to each other. In one example, as shown in FIG. 4A, four sub-pixels adjacent to each other may include a first sub-pixel SP_G, a second sub-pixel SP_B, a third sub-pixel SP_R, and a fourth sub-pixel SP_W to construct one pixel. The first sub-pixel SP_G, the second sub-pixel SP_B, the third sub-pixel SP_R, and the fourth sub-pixel SP_W may emit green, blue, red, and white light, respectively.

Referring to FIGs. 4A and 4B, the display device according to an aspect of the present disclosure may include a first substrate 100, a thin-film transistor TFT, a protective film 127, organic light-emitting elements 160G, 160B, 160R and 160W, a capping film 170, a second substrate 200, a black matrix 210, a color filter layer 215 and an overcoat layer 220.

The first substrate 100 and the second substrate 200 may be disposed to face each other. The first substrate 100 and the second substrate 200 may include a transparent material. For example, the first substrate 100 and the second substrate 200 may be made of glass or plastic. The first substrate 100 and the second substrate 200 may be bonded together, and the overcoat layer 220 of the second substrate 200 may come into contact with the capping film 170 of the first substrate 100.

In the first substrate 100, the thin-film transistor TFT is disposed for each of the sub-pixels SP_G, SP_B, SP_R, and SP_W. The thin-film transistor TFT may be covered by the protective film 127. The organic light-emitting elements 160G, 160B, 160R and 160W each including a first electrode, a light-emissive layer, and a second electrode may be disposed on the protective film 127. Light emitted from the organic light-emitting element 160 may pass through the color filter 215 and the second substrate 200 in order and be emitted to the outside. For example, light emitted from the organic light-emitting element 160 may be white light. The organic light-emitting elements 160G, 160B, 160R and 160W may be covered with the capping film 170.

The second substrate 200 may be positioned on the capping film 170 of the first substrate 100. The second substrate 200 may include a first surface 200a and a second surface 200b. The first surface 200a may be a light emitting surface through which light emitted from the organic light-emitting element 160 and passed through the color filter 215 is emitted to the outside. The second surface 200b, as a position opposite to the first surface 200a, may be an incident surface on which light emitted from the organic light-emitting element 160 is incident.

A black matrix 210 may be disposed on the second surface 200b of the second substrate 200. The black matrix 210 may be disposed corresponding to a boundary area of each of the sub-pixels SP_G, SP_B, SP_R, and SP_W. The black matrix 210 may include black resin or black ink, but may not be limited thereto. For example, the black matrix 210 may include an opaque material that does not transmit light.

The color filter layer 215 may be disposed on the black matrix 210. The color filter layer 215 may include a first color filter 215G, a second color filter 215B, and a third color filter 215R.

The color filter layer 215 may transmit, for example, light in a red wavelength range, light in a green wavelength range, and light in a blue wavelength range from the light emitted from the organic light-emitting element 160, and absorb light in other wavelength ranges such that light passing through the color filter layer 215 may render the red, green, and blue colors. To this end, the color filter layer 215 may include a fluorescent dye.

The first color filter 215G, the second color filter 215B, and the third color filter 215R respectively disposed to correspond to the first sub-pixel SP_G, the second sub-pixel SP_B, and the third sub-pixel SP_R may emit the green light, the blue light, and the red light, respectively. As the fourth sub-pixel SP_W corresponds to the white sub-pixel, the color filter layer is not disposed on the fourth sub-pixel SP_W. As the color filter layer 215 is disposed to have different heights on the respective sub-pixels, a step may be included in the boundary area of the sub-pixels SP_G, SP_B, SP_R, and SP_W.

The overcoat layer 220 may be disposed on the color filter layer 215 including the first color filter 215G, the second color filter 215B, and the third color filter 215R. The overcoat layer 220 may cover the exposed surface of the color filter layer 215.

Moreover, the overcoat layer 220 may have a flat surface while covering the steps formed as the color filters are disposed to overlap with each other in the boundary areas of the sub-pixels SP_G, SP_B, SP_R, and SP_W. For example, the overcoat layer 220 may contain a negative-type photoactive compound (negative PAC). The negative-type photoactive compound may be understood as a compound in which a light receiving portion remains. In this regard, because the color filter layer is not disposed in the area corresponding to the fourth sub-pixel SP_W, only the overcoat layer 220 may be disposed on the second substrate 200 in such area.

As the overcoat layer 220 covers the exposed surface of the color filter, the color filter may not be damaged during the cleaning process to remove foreign substances. Accordingly, by preventing an occurrence of dark spots on the display area resulted from the foreign substances or the like, reliability of a product may be improved.

In such display area AA of the display device according to the aspect of the present disclosure, the green light, which is of a first color, may be emitted from the first sub-pixel SP_G via the first color filter 215G, the blue light, which is of a second color, may be emitted from the second sub-pixel SP_B via the second color filter 215B, and the red light, which is of a third color, may be emitted from the third sub-pixel SP_R via the third color filter 215R. In addition, as the color filter layer is not disposed on the fourth sub-pixel SP_W, the white light emitted from the organic light-emitting element 160 may be emitted from the fourth sub-pixel SP_W. Accordingly, the first sub-pixel SP_G, the second sub-pixel SP_B, and the third sub-pixel SP_R may be the colored sub-pixels of the green sub-pixel, the blue sub-pixel, and the red sub-pixel, respectively, and the fourth sub-pixel SP_W may be the white sub-pixel.

In one example, referring back to FIG. 1, the dam pattern 230 may be disposed on the outermost portion of the display area AA, the non-light-emissive areas PAD and NPAD excluding the display area AA, and the boundary areas of the display area AA and the non-light-emissive areas PAD and NPAD. The non-light-emissive areas PAD and NPAD may surround the display area AA, and may include the pad area PAD and the non-pad area NPAD. In this regard, the pad area PAD may be an area where the printed circuit board PCB and the flexible circuit board FPCB are disposed, and the non-pad area NPAD may be an area including the portion of the edge at the other side opposite to the pad area PAD excluding the removed area DA that is removed by the cutting line CL from the display panel PNL that may be cut.

The dam pattern 230 may be disposed to surround the four edges of the display device. The dam pattern 230 prevents the moisture from invading from the side of the display device, thereby preventing a performance of the display device from deteriorating due to the damage to the organic light-emitting element caused by the moisture invasion.

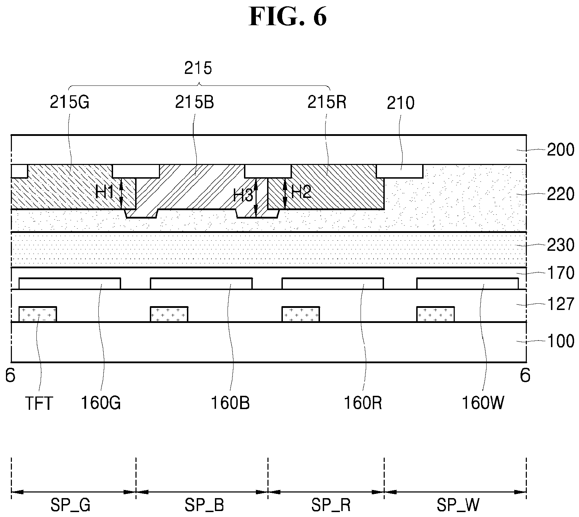

FIG. 5 is an enlarged plan view of area 5 shown in FIG. 1. In addition, FIG. 6 is a cross-sectional view taken along arrow 6-6 in FIG. 5. In this regard, FIG. 5 shows a structure corresponding to a pixel area PX_NAA disposed in the pad area PAD among the non-light-emissive areas PAD and NPAD. FIG. 5 shows only the components of the overcoat layer 220 disposed on the sub-pixels SP_G, SP_B, SP_R, and SP_W among various components of the pixel area for convenience of description.

Referring to FIGs. 5 and 6, the overcoat layer 220 may be disposed on a front surface of an area corresponding to sub-pixels SP_G, SP_B, SP_R, and SP_W disposed on the pixel area PX_NAA disposed in the pad area PAD among the non-light-emissive areas PAD and NPAD.

The color filter layer 215 may have different heights on the sub-pixels SP_G, SP_B, SP_R, and SP_W. For example, the first color filter 215G may have a first height H1 on a portion of the second substrate 200 corresponding to the first sub-pixel SP_G, and the third color filter 215R may have a second height H2 on a portion of the second substrate 200 corresponding to the third sub-pixel SP_R. In this regard, the first height H1 and the second height H2 may be different from each other.

As the second color filter 215B is disposed to overlap with the top surfaces of the first color filter 215G and the third color filter 215R, the second color filter 215B may have a third height H3 on a portion of the second substrate 200 corresponding to the second sub-pixel SP_B. The third height H3 may be different from the first height H1 and the second height H2. Moreover, since the color filter layer is not disposed on the portion of the second substrate 200 corresponding to the fourth sub-pixel SP_W, the corresponding area may have a height different from that of the area in which the color filters 215B, 215G, and 215R are disposed.

As such, the color filters 215B, 215G, and 215R have different heights H1, H2, and H3 in the area where they are disposed, and are disposed to overlap with each other in a vertical direction in the boundary areas of the sub-pixels SP_G, SP_B, SP_R, and SP_W, so that steps may be included.

When the dam pattern is disposed on the first substrate 100 with the steps remaining between the color filters 215B, 215G, and 215R disposed on the pad area PAD among the non-light-emissive areas PAD and NPAD, and the first substrate 100 is bonded with the second substrate 200, in the portion where the steps between the color filters 215B, 215G, and 215R remain, it may be difficult for the dam pattern to be completely in close contact with the second substrate 200. Then, as it becomes difficult for the first substrate 100 and the second substrate 200 to be bonded together while completely being in close contact with each other, a void may occur in the portion where the steps between the color filters 215B, 215G, and 215R remain. As such void acts as the moisture invading path, the damage may occur to the organic light-emitting element, and as a result, a problem of deteriorating a quality of the display device may occur.

On the other hand, in the aspect of the present disclosure, the overcoat layer 220 is disposed on the front surfaces of the color filters 215B, 215G, and 215R in the area corresponding to the sub-pixels SP_G, SP_B, SP_R, and SP_W disposed on the pixel area PX_NAA disposed in the pad area PAD among the non-light-emissive areas PAD and NPAD. The overcoat layer 220 may have a thickness sufficient to fill the steps between the color filters 215B, 215G, and 215R. Accordingly, the overcoat layer 220 may have a flat surface on a side facing the first substrate 100. The overcoat layer 220 may include a negative-type photoactive compound (negative PAC).

The dam pattern 230 may be disposed on the encapsulating layer 170 of the first substrate 100. In addition, the dam pattern 230 may be in contact with and bonded with the flat surface of the overcoat layer 220 of the second substrate 200.

Among the non-light-emissive areas PAD and NPAD, the non-pad area NPAD may additionally block the moisture invading path. This will be described below with reference to FIGs. 7 to 11.

FIG. 7 is an enlarged plan view of area 7 shown in FIG. 1. In this regard, FIG. 7 shows a structure corresponding to the pixel area PX_NAA disposed in the non-pad area NPAD among the non-light-emissive areas PAD and NPAD. FIG. 7 shows only the components of the overcoat layer 220 disposed on the sub-pixels SP_G, SP_B, SP_R, and SP_W among the various components of the pixel area for convenience of description.

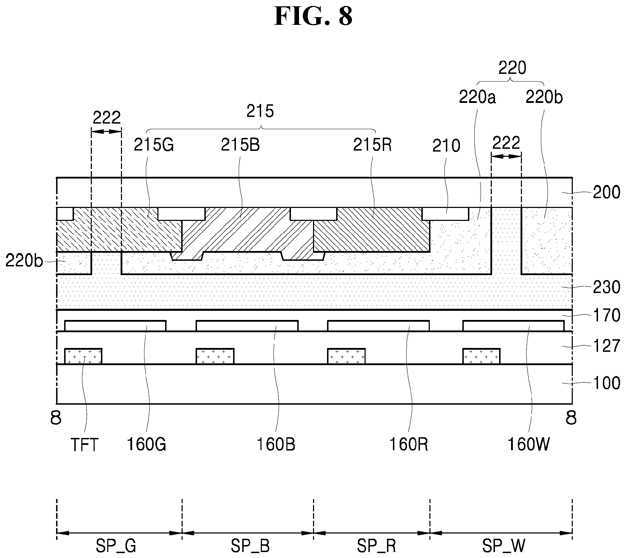

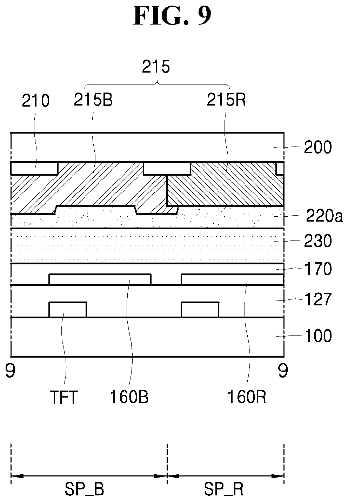

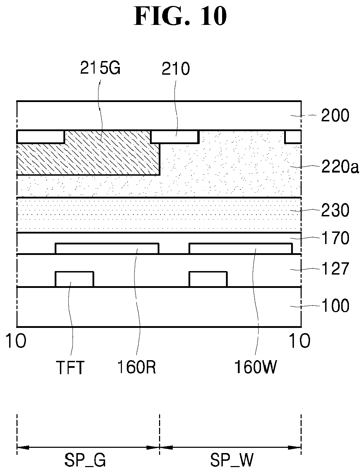

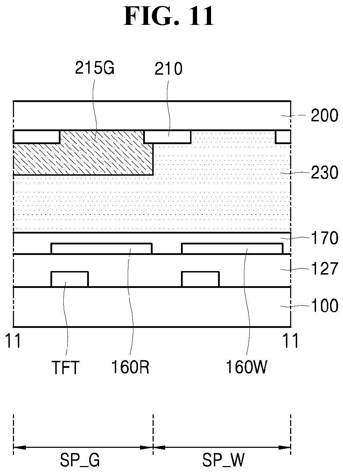

FIGs. 8 to 11 are views schematically showing cross-sections of respective portions in FIG. 7. Specifically, FIG. 8 is a cross-sectional view taken along arrow 8-8 in FIG. 7. FIG. 9 is a cross-sectional view taken along arrow 9-9 in FIG. 7. FIG. 10 is a cross-sectional view taken along arrow 10-10 in FIG. 7. In addition, FIG. 11 is a cross-sectional view taken along arrow 11-11 in FIG. 7.

Referring to FIGs. 7 and 8 along with FIG. 1, the overcoat layer 220 may be disposed on the front surface of the area corresponding to the sub-pixels SP_G, SP_B, SP_R, and SP_W disposed on the pixel area PX_NAA disposed in the non-pad area NPAD among the non-light-emissive areas PAD and NPAD.

The overcoat layer 220 may have a flat surface while filling the steps between the color filters 215B, 215G, and 215R. The overcoat layer 220 may include a negative-type photoactive compound (negative PAC).

The overcoat layer 220 disposed in the non-pad area NPAD may include a first pattern 220a, a second pattern 220b, and a slit pattern 222. The slit pattern 222 may extend perpendicular to the moisture invading path direction VP in the non-pad area NPAD. For example, when the moisture invading path direction VP is the X-axis direction, which is the first direction, the slit pattern 222 may be disposed in the Y-axis direction, which is the second direction perpendicular to the X-axis direction. Moreover, the slit pattern 222 may be disposed to extend in a direction parallel to a direction of the long side of the display panel PNL and perpendicular to a direction of the short side.

The overcoat layer 220 may include the first pattern 220a and the second pattern 220b disposed on both sides with the slit pattern 222 therebetween. The first pattern 220a may be disposed to cover the second color filter 215B and the third color filter 215R and to cover a partial area of the second substrate 200 corresponding to the second color filter 215G and the fourth sub-pixel SP_W. The second pattern 220b may be spaced apart from the first pattern 220a by a width of the slit pattern 222 and may be disposed to cover a partial area of the second substrate 200 corresponding to the second color filter 215G and the fourth sub-pixel SP_W.

The slit pattern 222 may be disposed to overlap with the area corresponding to the fourth sub-pixel SP_W where the color filter is not disposed. For example, the fourth sub-pixel SP_W may be the white sub-pixel. Disposing the slit pattern 222 on the fourth sub-pixel SP_W may minimize an area where the color filter and the dam pattern 230 come into contact with each other because there is no color filter on the fourth sub-pixel SP_W.

FIG. 9 shows a cross-section of an area where the second color filter 215B and the third color filter 215R are disposed in the area where the first pattern 220a of the overcoat layer 220 is disposed.

Referring to FIG. 9, the first pattern 220a of the overcoat layer 220 may be disposed to cover the second color filter 215B and the third color filter 215R. Accordingly, the dam pattern 230 may be disposed in contact with a flat surface of the first pattern 220a of the overcoat layer 220.

FIG. 10 shows a cross-section of an area corresponding to the first color filter 215G and the fourth sub-pixel SP_W where the color filter is not disposed of the area where the first pattern 220a of the overcoat layer 220 is disposed.

Referring to FIGs. 7 and 10, the first pattern 220a of the overcoat layer 220 may be disposed to cover the area corresponding to the first color filter 215G and the fourth sub-pixel SP_W of the second substrate 200. Accordingly, the dam pattern 230 may be disposed in contact with the flat surface of the first pattern 220a of the overcoat layer 220. A boundary area between the area corresponding to the first color filter 215G and the area corresponding to the fourth sub-pixel SP_W in which the color filter is not disposed has a step with a height small than that of the area in which the color filters are disposed to overlap with each other. The first pattern 220a of the overcoat layer 220 may flatten the step in the boundary area between the area corresponding to the first color filter 215G and the area corresponding to the fourth sub-pixel SP_W.

FIG. 11 shows a cross-section of the area where the slit pattern 222 disposed between the first pattern 220a and the second pattern 220b of the overcoat layer 220 is disposed.

Referring to FIGs. 7 and 11, because the portion where the slit pattern 222 is disposed is an area where the overcoat layer 220 is not disposed, the dam pattern 230 is disposed while filling the slit pattern 222 between the first pattern 220a and the second pattern 220b of the overcoat layer 220. Accordingly, while the moisture invading path is blocked by the slit pattern 222, the moisture invading path may be additionally blocked by the dam pattern 230. As the moisture invading path is blocked, a performance and a lifespan of the organic light-emitting element disposed inside the display area may be maintained for a long time, so that the display device may be driven even with low power, which has an effect of reducing power consumption.

In one example, when the first color filter 215G whose surface is partially not covered with the slit pattern 222 disposed across the non-pad area NPAD comes into direct contact with the dam pattern 230, adhesion may be further improved.

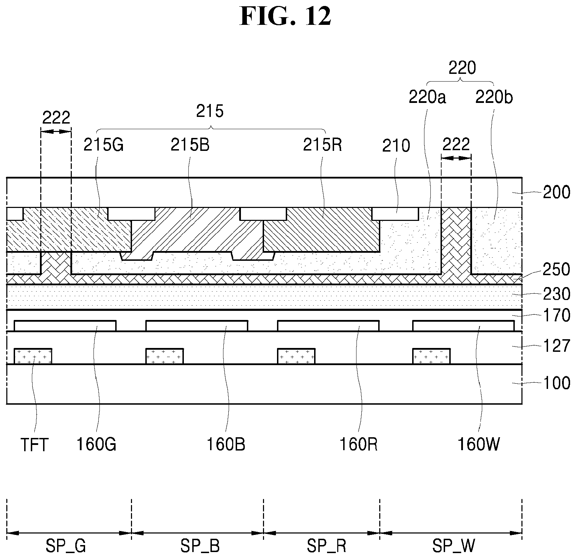

FIG. 12 is a cross-sectional view showing a display device according to another aspect of the present disclosure. Because the display device according to another aspect of the present disclosure is the same as the display device in FIG. 8 except for a configuration of a barrier layer, portions with differences will be mainly described and redundant descriptions will be omitted.

Referring to FIG. 12, a barrier layer 250 may be disposed between the overcoat layer 220 and the dam pattern 230.

The barrier layer 250 may be disposed to fill the slit pattern 222 between the first pattern 220a and the second pattern 220b of the overcoat layer 220 and extend onto the overcoat layer 220. As a result, the barrier layer 250 may flatten the step in the boundary area between the area corresponding to the first color filter 215G and the area corresponding to the fourth sub-pixel SP_W.

The barrier layer 250 may fill the slit pattern 222 and separate the first pattern 220a and the second pattern 220b from each other, thereby additionally blocking the moisture invading path. To this end, the barrier layer 250 may include an inorganic insulating film. For example, the barrier layer 250 may have a single-layer or multi-layer structure of an inorganic insulating film containing silicon oxide SiOx or silicon nitride SiNx.

As the barrier layer 250 is disposed between the overcoat layer 220 and the dam pattern 230, one surface of the barrier layer 250 is in contact with the overcoat layer 220 and the other surface of the barrier layer 250 is in contact with the dam pattern 230. Moreover, in an area corresponding to the first sub-pixel SP_G and where the slit pattern 222 is disposed, one surface of the barrier layer 250 may be in contact with the second color filter 215G and the other surface thereof may in contact with the dam pattern 230. Accordingly, the adhesion may be improved compared to a case in which the first color filter 215G not covered with the slit pattern 222 and the dam pattern 230 are in direct contact with each other.

A display device according to an aspect of the present disclosure may be described as follows.

One aspect of the present disclosure provides a display device comprising: a display panel including a display area and a non-pad area located outwardly of the display area; a plurality of sub-pixels disposed on the display panel and a plurality of color filters disposed at positions respectively corresponding to the plurality of sub-pixels; a dam pattern at least disposed on the non-pad area of the display panel; and an overcoat layer disposed between the color filters and the dam pattern.

In some implementations of the display device, the display panel includes: a first substrate with the plurality of sub-pixels including a first sub-pixel, a second sub-pixel, a third sub-pixel, and a fourth sub-pixel disposed thereon; and a second substrate disposed to face the first substrate and including the plurality of color filters disposed at positions respectively corresponding to the first to the third sub-pixels except for the fourth sub-pixel, wherein the overcoat layer is located on the plurality of color filters and has a flat surface.

In some implementations of the display device, color filters adjacent to each other among the plurality of color filters are disposed to overlap with each other in a boundary area of sub-pixels adjacent to each other among the plurality of sub-pixels to have a step, and the overcoat layer is disposed on the plurality of color filters including the step.

In some implementations of the display device, the display device further comprises: a pad area disposed on one side of the display panel opposite to the non-pad area; and a cutting line located at an edge at the other side of the display panel opposite to the pad area, wherein the cutting line adjusts a size of the display panel to be cut.

In some implementations of the display device, the overcoat layer includes a negative-type photoactive compound.

In some implementations of the display device, the overcoat layer disposed in the display area covers an exposed surface of the color filter and covers an exposed surface of the second substrate in an area corresponding to the fourth sub-pixel.

In some implementations of the display device, the overcoat layer disposed in the non-pad area includes a first pattern and a second pattern disposed on both sides with a slit pattern interposed therebetween.

In some implementations of the display device, the slit pattern is disposed to extend in a direction parallel to a direction of a long side of the display panel and perpendicular to a direction of a short side of the display panel.

In some implementations of the display device, the slit pattern is disposed to extend in a direction perpendicular to a moisture invading path direction.

In some implementations of the display device, the display device further comprises: a slit pattern located on the non-pad area, at least overlapping an area corresponding to the fourth sub-pixel, and extending to an area corresponding to the first sub-pixel adjacent to the fourth sub-pixel.

In some implementations of the display device, the slit pattern is filled with the dam pattern.

In some implementations of the display device, the display device further comprises: a barrier layer disposed between the overcoat layer and the dam pattern, wherein the barrier layer fills the slit pattern while one surface thereof is in contact with the second color filter and the other surface thereof is in contact with the dam pattern.

In some implementations of the display device, the display panel includes: a first substrate with a white sub-pixel and colored sub-pixels disposed thereon; and a second substrate positioned to face the first substrate and including the plurality of color filters, wherein the overcoat layer includes a slit pattern, and the slit pattern is disposed to overlap with the white sub-pixel.

According to the aspect of the present disclosure, the performance of the light-emitting element may be maintained by blocking the occurrence of the void, which is one of causes of the deterioration of the organic light-emitting element in the display device that may be cut.

To this end, as the overcoat layer having the flat surface is disposed on the color filter, the step between the color filters may be reduced and the adhesion may be improved. Therefore, the occurrence of the void may be prevented, so that reliability degradation may be prevented.

As a plurality of slit patterns are disposed in the direction perpendicular to the moisture invading path direction on the non-pad area, the invasion of the moisture to the display area may be blocked. Therefore, the performance of the light-emitting element disposed inside the display device may be stably maintained, which may improve the reliability of the product.

As the overcoat layer for covering the exposed surface of the color filter is disposed, the foreign substances may be removed by cleaning the substrate without damaging the color filter. Therefore, the occurrence of the dark spots on the display area may be prevented.

It will be apparent to those skilled in the art that various modifications and variations can be made in the display device of the present disclosure without departing from the spirit or scope of the aspects. Thus, it is intended that the present disclosure covers the modifications and variations of the aspects provided they come within the scope of the appended claims and their equivalents.

Also disclosed herein are the following numbered clauses:
1. A display device comprising:
   first and second substrates facing each other;
   first, second, third and fourth organic light-emitting elements disposed on the first substrate in a non-emissive area;
   a dam pattern disposed on the first, second, third and fourth organic light-emitting elements;
   first, second, third and fourth sub-pixels disposed on the display panel;
   first, second and third color filters disposed to respectively correspond to the first, second, and third organic light-emitting elements;
   an overcoat layer disposed on the second substrate including the first, second and third color filter layers; and
   a barrier layer disposed between the dam pattern and the overcoat layer and having first and second portions overlapping with the second organic light-emitting element and the fourth organic light-emitting element.
2. The display device of clause 1, wherein the overcoat layer includes first and second patterns spaced apart from each other by a width of the first and second portions of the barrier layer.
3. The display device of clause 1, wherein the overcoat layer includes a negative-type photoactive compound.
4. The display device of any preceding clause, wherein the barrier layer extends in a direction parallel to a direction of a long side of a display panel and perpendicular to a direction of a short side of the display panel.
5. The display device of any preceding clause, wherein the barrier layer has one surface is in contact with the second color filter and another surface is in contact with the dam pattern.
6. The display device of any preceding clause, wherein the barrier layer has one surface is in contact with the second substrate and another surface is in contact with the dam pattern.
7. The display device of any preceding clause, wherein the second portion of the barrier layer has a length greater than that of the first portion of the barrier layer.
8. The display device of any preceding clause, further comprising a first connection line disposed between two adjacent organic light-emitting elements, and a second connection line perpendicular to the first connection line and disposed between two adjacent organic light-emitting elements.

## Claims

1. A display device comprising:
a display panel including a light emitting area and a non-light emitting area located outside the light emitting area;
a plurality of sub-pixels disposed on the display panel;
a plurality of color filters disposed to respectively correspond to the plurality of sub-pixels;
a dam pattern disposed at least on the non-light emitting area of the display panel;
an overcoat layer disposed between the color filters and the dam pattern; and
a slit pattern located in close proximity to a cutting area of the non-light emitting area.

2. The display device of claim 1, wherein the display panel includes:
a first substrate with the plurality of sub-pixels including a first sub-pixel, a second sub-pixel, a third sub-pixel, and a fourth sub-pixel disposed thereon; and
a second substrate facing the first substrate and including the plurality of color filters disposed to respectively correspond to the first to the third sub-pixels except for the fourth sub-pixel,
wherein the overcoat layer is located on the plurality of color filters and has a flat surface.

3. The display device of claim 2, wherein adjacent color filters among the plurality of color filters overlap with each other in a boundary area of the plurality of sub-pixels adjacent to each other among the plurality of sub-pixels and have a step, and the overcoat layer is disposed on the plurality of color filters including the step.

4. The display device of any preceding claim, further comprising a cutting line located at an edge of another side of the display panel,
wherein a size of the display panel is configured to be adjusted by the cutting line where the display panel is to be cut.

5. The display device of any preceding claim, wherein the overcoat layer includes a negative-type photoactive compound.

6. The display device of any of claims 2 to 5, wherein the overcoat layer disposed in the display area covers an exposed surface of the color filter and covers an exposed surface of the second substrate in an area corresponding to the fourth sub-pixel.

7. The display device of any preceding claim, wherein the overcoat layer disposed in the non-light emitting area includes a first pattern and a second pattern disposed on the slit pattern interposed therebetween.

8. The display device of claim 7, wherein the slit pattern extends in a direction parallel to a direction of a long side of the cutting area.

9. The display device of claim 7, wherein the slit pattern extends in a direction perpendicular to a direction of a moisture invading path.

10. The display device of any of claims 2 to 9, wherein the slit pattern extends through an area corresponding to the second sub-pixel and the fourth sub-pixel adjacent to the second sub-pixel, and
wherein the slit pattern does not extend through an area corresponding to the first sub-pixel and the third sub-pixel adjacent to the first sub-pixel .

11. The display device of any of claims 7 to 10, wherein the slit pattern is filled with the dam pattern.

12. The display device of any of claims 7 to 11, further comprising a barrier layer disposed between the overcoat layer and the dam pattern,
wherein the barrier layer fills the slit pattern and has one surface is in contact with the second color filter and another surface is in contact with the dam pattern.

13. The display device of any preceding claim, wherein the display panel includes:
a first substrate with a white sub-pixel and colored sub-pixels disposed thereon; and
a second substrate positioned to face the first substrate and including the plurality of color filters,
wherein the overcoat layer includes a slit pattern, and the slit pattern overlaps with the white sub-pixel.

14. The display device of any preceding claim, further comprising a first connection line disposed between two adjacent sub-pixels among the plurality of sub-pixels, and a second connection line perpendicular to the first connection line and disposed between two adjacent sub-pixels among the plurality of sub-pixels.
